# EUROPEAN PATENT APPLICATION

(11) **EP 4 614 741 A1**
(43) Date of publication of application: **10.09.2025**
(21) Application number: 24162242.2
(22) Date of filing: 08.03.2024
(51) Int. Cl.: H02B 1/38, E05D 7/10, H05K 5/02, H02B 1/44

(54) **ELECTRICAL ENCLOSURE**

(71) Applicant: Hager Industrial De Envolventes SAU, 08430 La Roca del Valles (ES)
(72) Inventor: Tornos, Sergi, 08480 L Ametlla del Valles (ES); Robreño, Carlos Francisco, 08034 Barcelona (ES)
(74) Representative: Hagergroup

(57) **Abstract**

An electrical enclosure comprises a main body (20) and a door (30). The electrical enclosure (10) comprises a hinge mechanism through which the door (30) is rotatably mounted to a door frame (22) of the main body (20). The hinge mechanism (40) comprises a knuckle (50) and a hinge pin (60) defining an axis of rotation (A) of the door (30). The hinge mechanism (40) comprises a sliding element (42) configured to adopt a first position (P1), in which the hinge pin (60) is received in the knuckle (50) such that the hinge pin (60) is held within the knuckle (50) against any displacement orthogonal to the axis of rotation (A), and a second position (P2), in which the hinge pin (60) is released from the knuckle (50) such that the hinge pin (60) is free to be displaced out of the knuckle (50) in at least one direction orthogonal to the axis of rotation (A).

## Description

The present invention relates to an enclosure, more particularly to an electrical enclosure, and even more particularly to an electrical enclosure comprising a main body providing an interior space, and a door.

Electrical enclosures are designed to permit access to the interior space by persons operating or servicing the electrical enclosures or components housed in the interior space. In order to access the components, for example for the purpose of their activation, the door of the enclosure is opened. In some cases, the door may be entirely removed, for instance by unscrewing a door frame, to facilitate the service of the components arranged in the interior space.

Generally, the door is rotatably mounted on the main body between at least an open position and a closed position. The opened position of the door allows to permit access to the components arranged in the interior space of the main body.

In an electrical enclosure known for prior art document EP 2 645 499 A2, the door is rotatably mounted to the main body by means of a hinge pin protruding from the door and received in a screw hole arranged in a hinge base of the main body.

However, the aforementioned electrical enclosures are difficult and time consuming to assemble. In particular, it is time consuming to rotatably mount the door to the main body or to temporarily remove the door for the purpose wiring the components housed in the interior space of the electrical enclosure for example.

The objective of the present invention is to provide an electrical enclosure which is fast and easy to assemble. It is a further object of the present invention to provide a method for assembling such electrical enclosure which easy and fast to carry out.

In accordance with the present invention, there is provided an electrical enclosure comprising a main body and a door. The main body comprises a door frame, a rear wall, a first side wall, a second side wall, a third side wall and a fourth side wall. The rear wall, the first side wall, the second side wall, the third side wall and the fourth side wall that define an interior space for receiving electrical devices. The electrical enclosure further comprises a hinge mechanism through which the door is rotatably mounted to the door frame of the main body, the hinge mechanism comprising at least a knuckle and at least a hinge pin defining an axis of rotation of the door.

The electrical enclosure according to the present invention is characterized in that the hinge mechanism comprises a sliding element configured to adopt a first position, in which the hinge pin is received in the knuckle such that the hinge pin is held within the knuckle against any displacement orthogonal to the axis of rotation, and a second position, in which the hinge pin is released from the knuckle such that the hinge pin is free to be displaced out of the knuckle in at least one direction orthogonal to the axis of rotation.

Advantageously, the sliding element is configured to be moved to the first position by a movement along a sliding direction parallel to the plane within which the door lies when the door is in a closed position and/or perpendicular to the axis of rotation, in particular configured to be moved from the second position to the first position by a movement parallel to the plane within which the door lies when the door is in a closed position and/or perpendicular to the axis of rotation.

According to a preferred embodiment, the sliding element further comprises a first retainment means, the first retainment means having a first abutment surface, the hinge mechanism further comprising a second abutment surface, the first abutment surface being configured to rest against the second abutment surface to hold the sliding element in the first position.

Preferably, the hinge mechanism further comprises a third abutment surface, the first abutment surface being configured to rest against the third abutment surface when the sliding element is in the second position.

According to a preferred embodiment, the sliding element further comprises a release means configured to displace the first retainment means to separate the first abutment surface from the second abutment surface and/or to separate the first abutment surface from the third abutment surface when pushed by a user.

Preferably, the sliding element comprises a resilient tongue, the first retainment means being formed on the resilient tongue, the resilient tongue substantially lying in a plane which is parallel to the axis of rotation and/or parallel to the plane within which the door lies when the door is in a closed position.

According to a preferred embodiment, the hinge pin is formed on the frame of the main body.

Preferably, the door comprises a receiving portion to which the sliding element is attached in the first position and/or the second position, wherein preferably the second abutment surface and/or the third abutment surface are formed on the receiving portion.

According to a preferred embodiment, the knuckle comprises at least two parts, a first part of the at least two parts being formed on the sliding element, wherein preferably a second part of the at least two parts is formed on the door or the main body.

Preferably, the sliding element further comprises a second retainment means, the second retainment means having a fourth abutment surface and the hinge mechanism further comprising a fifth abutment surface, the fourth abutment surface being configured to rest against the fifth abutment surface to hold the sliding element in the second position.

In accordance with the present invention, there is further provided a method for assembling an electrical enclosure according to the invention, the method comprising the following steps:
a. providing the main body, the door and the sliding element of the electrical enclosure;
b. positioning the door within the frame of the main body;
c. moving the sliding element into the first position to receive the hinge pin in the knuckle such that the hinge pin is held within the knuckle against any displacement orthogonal to the axis of rotation.

According to a preferred embodiment, in step c., the sliding element is moved into the first position by a movement parallel to the plane within which the door lies when the door is in a closed position and/or perpendicular to the axis of rotation.

Preferably, in step c., a first abutment surface of the first retainment means of the sliding element is put to rest against the second abutment surface of the hinge mechanism.

According to a preferred embodiment, in step c., in the first position, the sliding element is attached to the receiving portion of the door.

Preferably, in step c., the knuckle is formed by pushing one of the at least two parts towards another of the at least two parts.

Further benefits and advantages of the present invention will become apparent after a careful reading of the detailed description with appropriate reference to the accompanying drawings.

In the drawings:

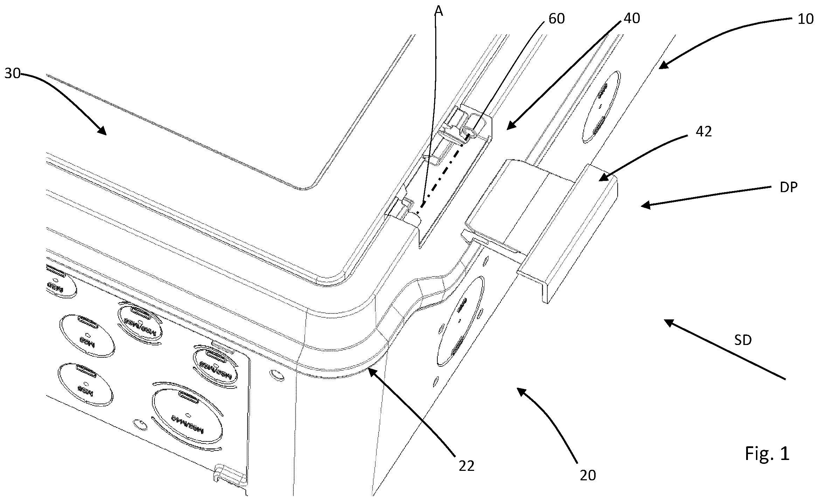

Fig. 1 is a perspective view of an electrical enclosure according to a preferred embodiment of the present invention;
Fig. 2 is a further perspective view of the electrical enclosure according to the preferred embodiment, where a sliding element of the electrical enclosure takes a second position;
Fig. 3 is a perspective view of the sliding element of the electrical enclosure according the preferred embodiment;
Fig. 4 is a bottom view of the electrical enclosure showing the sliding element and a receiving section of the electrical enclosure according to the preferred embodiment, the sliding element taking the second position;
Fig. 5 is a cross sectional view of the electrical enclosure where the sliding element takes the second position;
Fig. 6 is a bottom view of the electrical enclosure showing the sliding element and the receiving section of the electrical enclosure according to the preferred embodiment, the sliding element taking the first position;
Fig. 7 is a cross sectional view of the electrical enclosure where the sliding element takes the first position; and

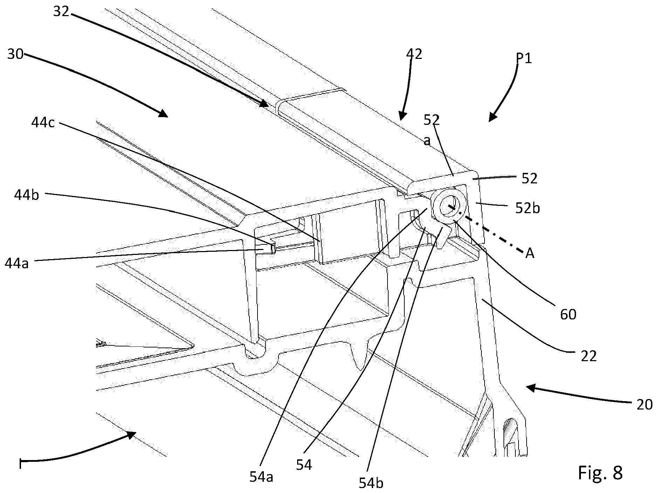

Fig. 8 is a perspective cross sectional view of the electrical enclosure where the sliding element takes the first position.

Referring to the drawings, an electrical enclosure 10 according to the preferred embodiment comprises a main body 20 and a door 30. The main body 20 comprises a door frame 22, a rear wall, a first side wall, a second side wall, a third side wall and a fourth side wall. The rear wall, the first side wall, the second side wall, the third side wall and the fourth side wall define an interior space I for receiving electrical devices.

The electrical enclosure 10 comprises a hinge mechanism through which the door 30 is rotatably mounted to the door frame 22 of the main body 20. The hinge mechanism 40 comprises at least a knuckle 50 and at least a hinge pin 60 defining an axis of rotation A of the door 30.

The hinge mechanism 40 comprises a sliding element 42 configured to adopt a first position P1, in which the hinge pin 60 is received in the knuckle 50 such that the hinge pin 60 is held within the knuckle 50 against any displacement orthogonal to the axis of rotation A, and a second position P2, in which the hinge pin 60 is released from the knuckle 50 such that the hinge pin 60 is free to be displaced out of the knuckle 50 in at least one direction orthogonal to the axis of rotation A.

The first position P1 may be referred to as the clipped position of the sliding element 42 and the second position P2 may be referred to as the pre-clipped position of the sliding element 42.

The hinge mechanism 40 may comprise two or more knuckles 50 and at two or more hinge pins 60 together defining the axis of rotation A of the door 30. According to the preferred embodiment, the hinge mechanism 40 comprises two knuckles 50 and at two hinge pins 60 together defining the axis of rotation A of the door 30.

According to the present embodiment, when the sliding element 42 is moved into the first position P1, the knuckle 50 is formed around the hinge pin 60 to encase the hinge pin 60. The first position P1 may also be referred to as a closed position of the knuckle 50. When the sliding element 42 is moved from the first position P1 to the second position P2, an opening 56 is formed in the knuckle 50 permitting the hinge pin 60 to be displaced in at least one direction orthogonal to the axis of rotation A. The second position P2 may also be referred to as an open position of the knuckle 50. The opening 56 is preferably larger than the diameter of the hinge pin 60.

Preferably, the sliding element 42 is moved from the second position P2 to the first position P1 by a linear movement in a sliding direction SD. Advantageously, the sliding direction SD is parallel to the plane within which the door 30 lies when the door 30 is in a closed position and/or perpendicular to the axis of rotation A.

The electrical enclosure 10 according to the preferred embodiment is assembled according to a method comprising the following steps:
a. providing the main body 20, the door 30 and the sliding element 42 of the electrical enclosure 10;
b. positioning the door 30 within the frame 22 of the main body 20;
c. moving the sliding element 42 into the first position P1 to receive the hinge pin 60 in the knuckle 50 such that the hinge pin 60 is held within the knuckle 50 against any displacement orthogonal to the axis of rotation A.

In the electrical enclosure according to the preferred embodiment, the hinge pin 60 is advantageously formed on the frame 22 of the main body 20 whereas the knuckle 50 is formed by the door 30 and the sliding element 42, the sliding element 42 being attached to a receiving portion 32 of the door 30. The knuckle 50 is formed by at least two parts 52, 54. The at least two parts 52, 54 form the knuckle 50 around the hinge pin 60 to encase the hinge pin 60 in the first position P1. A first part 52 of the at least two parts 52, 54 is formed on the sliding element 42. A second part 54 of the at least two parts 52, 54 is formed on the door 30. Accordingly, the first part 52 of the at least two parts 52, 54 is displaced relatively to the second part 54 of the at least two parts 52, 54 when the sliding element 42 is displaced relatively to the receiving portion.

In an alternative embodiment not depicted in the figures, the hinge pin 60 may be formed on the door 30 whereas the knuckle 50 may be formed by the main body 20 and the sliding element 42, the sliding element 42 being attached to a receiving portion of the main body 20. The at least two parts 52, 54 form the knuckle 50 around the hinge pin 60 to encase the hinge pin 60 in the first position P1. According to the alternative embodiment, the first part 52 of the at least two parts 52, 54 is formed on the sliding element 42. The second part 54 of the at least two parts 52, 54 is formed on the main body 20.

The hinge pin 60 is preferably disc-shaped or circular-shaped in a cross section perpendicular to the axis of rotation A.

According to the preferred embodiment, the at least two parts 52, 54 forming the knuckle 50 comprise two planar sections 52a, 52b, 54a, 54b forming an angle α. Preferably, the planar sections 52a, 52b, 54a, 54b are parallel to the axis of rotation A. The angle α preferably has a magnitude smaller than 180° and/or greater or equal than 90°. As an alternative, the at least two parts 52, 54 forming the knuckle 50 may be arc shaped.

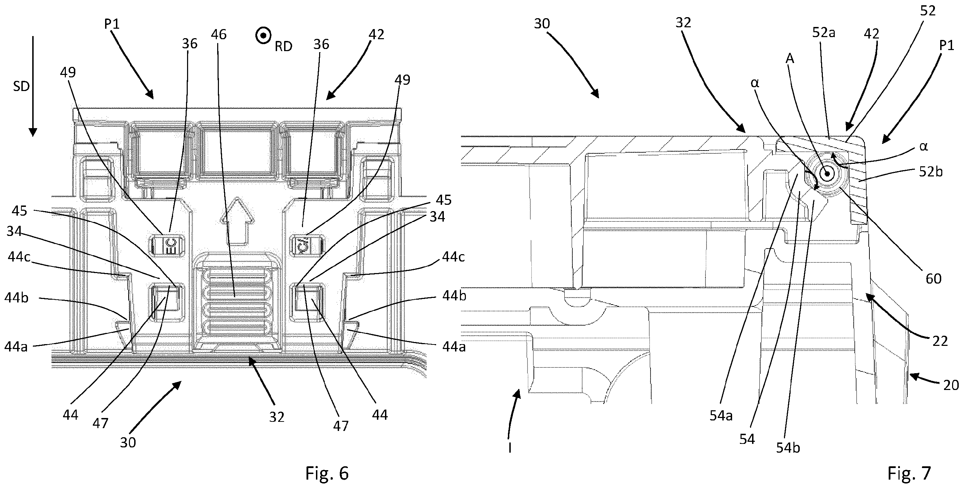

According to the preferred embodiment, the sliding element 42 comprises a first retainment means 44. The first retainment means 44 may be configured for establishing a snap-fit connection. The first retainment means 44 comprises a first abutment surface 45. The hinge mechanism 40 further comprises a second abutment surface 47. As depicted for instance in figure 6, the first abutment surface 45 is configured to rest against the second abutment surface 47 to hold the sliding element 42 in the first position P1.

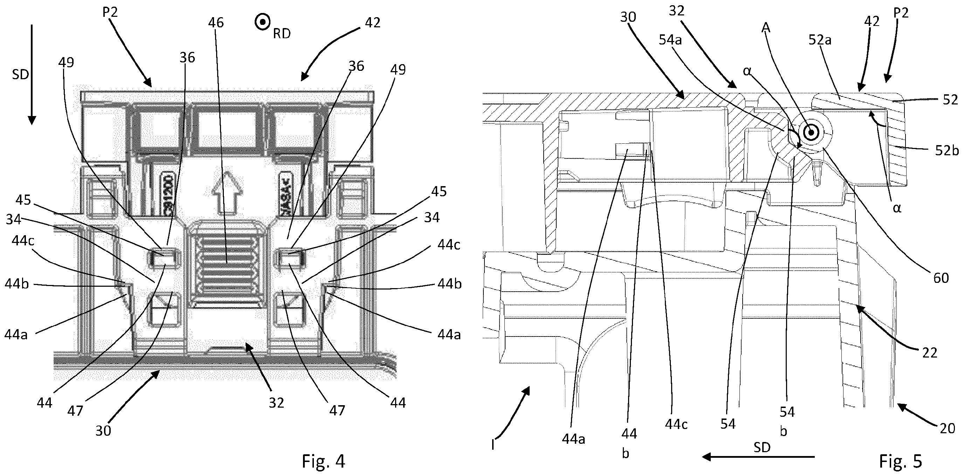

Preferably, as shown for instance in figure 4, the hinge mechanism 40 further comprises a third abutment surface 49, the first abutment surface 45 being configured to rest against the third abutment surface 49 when the sliding element 42 is in the second position P2.

According to the preferred embodiment, the first abutment surface 45 is formed on the sliding element. The second abutment surface 47 and/or the third abutment surface 49 are formed on the receiving portion 32 and/or the door 30.

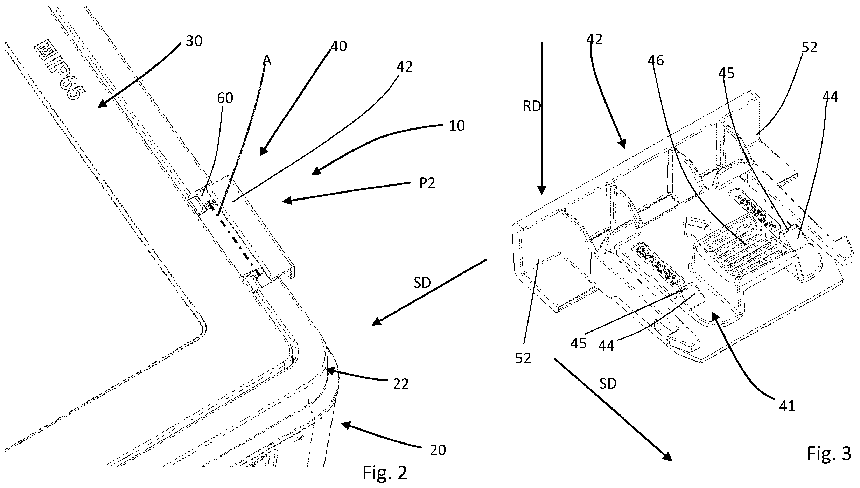

The sliding element 42 may further comprise a release means 46 configured to displace the first retainment means 44 to separate the first abutment surface 45 from the second abutment surface 47 and/or to separate the first abutment surface 45 from the third abutment surface 49 when pushed by a user in a release direction RD. The release direction RD is depicted in figures 3, 4 and 6. In figures 4 and 6, the release direction RD is perpendicular to the plan of projection of the corresponding figure.

The second abutment surface 47 is preferably formed on a first web 34 of the receiving portion 32 and/or the third abutment surface 49 is preferably formed on a second web 36 of the receiving portion 32.

Preferably, the sliding element 42 comprises a resilient tongue 41, the first retainment means 44 and/or release means 46 being formed on the resilient tongue 41, the resilient tongue 41 substantially lying in a plane which is parallel to the axis of rotation A and/or parallel to the plane within which the door 30 lies when the door 30 is in a closed position and/or perpendicular to the release direction RD.

The first retainment means 44 may further comprise a leading chamfer 43. The leading chamfer 43 extends in a plane which intersects the plane in which the resilient tongue 41 lies and the plane in which the first abutment surface 45 lies.

The sliding element 42 can further comprise a second retainment means 44a. The second retainment means 44a may be configured for establishing a snap-fit connection. The second retainment means 44a has a fourth abutment surface 44b and the hinge mechanism 40 further comprises a fifth abutment surface 44c, the fourth abutment surface 44b being configured to rest against the fifth abutment surface 44c to hold the sliding element 42 in the second position P2. The second retainment means 44a allows the sliding element 42 to be securely attached to the receiving portion 32 and prevents an unintentional detachment of the sliding element 42 from the receiving portion 32.

The second retainment means 44a may also further comprise a leading chamfer 43a. The leading chamfer 43a extends in a plane which intersects the plane in which the fourth abutment surface 44b lies.

Preferably, the second retainment means 44a is devoid of release means. That is, the second retainment means 44a is configured to permanently secure the sliding element 42 to the receiving portion 32 and/or to prevent the sliding element 42 to be unintentionally displaced from the second position P2 against the sliding direction SD.

Even if the second retainment means 44a is devoid of release means, the fourth abutment surface 44b may still be removed from the fifth abutment surface 44c to displace the sliding element against the sliding direction SD beyond the second position P2 to detach the sliding element 42 from the receiving portion 32 by acting on the second retainment means 44a using a tool like a screwdriver for instance. The direction in which the fourth abutment surface 44b may be removed from the fifth abutment surface 44c is preferably nonparallel to the release direction RD, even more preferably perpendicular to the release direction RD.

According to a preferred embodiment, the first abutment surface 45, the second abutment surface 47, the third abutment surface 49, the fourth abutment surface 44b and/or the fifth abutment surface 44c lie in a plane which is perpendicular to the sliding direction SD.

When assembling the electrical enclosure 10 according to the present embodiment, in step c., the sliding element 42 is moved from a detached position DP of the sliding element 42 towards the second position P2 and further towards the first position P1, preferably by a movement in the sliding direction SD. In the first position P1, the knuckle 50 is formed around the hinge pin 60.

In the preferred embodiment, in step c., the sliding element 42 can be moved into the first position P1 by a movement in the sliding direction SD, that is parallel to the plane within which the door 30 lies when the door 30 is in a closed position and/or perpendicular to the axis of rotation A.

Preferably, in step c., the first abutment surface 45 is put to rest against the second abutment surface 47.

When the sliding element 42 is moved from the detached position DP into the second position P2 by a movement parallel to the sliding direction SD, the leading chamfer 43 of the first retainment means 44 is pushed against the second web 36, thereby displacing the first retainment means 44 in a direction orthogonal to the sliding direction SD and/or in the release direction RD, preferably by elastic deformation of the tongue 41. Once the sliding element 42 reaches the second position P2, the tongue 41 resiles such that the first abutment surface 45 is put to rest against the second abutment surface 47.

Additionally, when the sliding element 42 is moved from the detached position DP into the second position P2 by a movement parallel to the sliding direction SD, the leading chamfer 43a of the second retainment means 44a is pushed against a part of the receiving portion 32 thereby displacing the second retainment means 44a in a direction orthogonal to the sliding direction SD and/or orthogonal to the release direction RD, preferably by elastic deformation of the second retainment means 44a. Once the sliding element 42 reaches the second position P2, the second retainment means 44a resiles such that the fourth abutment surface 44b is put to rest against the fifth abutment surface 44b.

When the sliding element 42 is further moved from the second position P2 into the first position P1 by a movement parallel to the sliding direction SD, the leading chamfer 43 of the first retainment means 44 is pushed against the first web 34, thereby displacing the first retainment means 44 in a direction orthogonal to the sliding direction SD and/or in the release direction RD, preferably by elastic deformation of the tongue 41. Once the sliding element 42 reaches the first position P1, the tongue 41 resiles such that the first abutment surface 45 is put to rest against the third abutment surface 49.

Advantageously, in step c., the sliding element 42 is attached to the receiving portion 32 of the door 30 in the first position P1 and/or the second position P2.

In step c., the knuckle 50 may be formed by pushing one of the at least two parts 52, 54 towards another of the at least two parts 52, 54.

## Claims

1. Electrical enclosure comprising a main body (20) and a door (30), the main body (20) comprising a door frame (22), a rear wall, a first side wall, a second side wall, a third side wall and a fourth side wall, the rear wall, the first side wall, the second side wall, the third side wall and the fourth side wall defining an interior space (I) for receiving electrical devices, the electrical enclosure (10) comprising a hinge mechanism through which the door (30) is rotatably mounted to the door frame (22) of the main body (20), the hinge mechanism (40) comprising at least a knuckle (50) and at least a hinge pin (60) defining an axis of rotation (A) of the door (30), **characterized in that** the hinge mechanism (40) comprises a sliding element (42) configured to adopt a first position (P1), in which the hinge pin (60) is received in the knuckle (50) such that the hinge pin (60) is held within the knuckle (50) against any displacement orthogonal to the axis of rotation (A), and a second position (P2), in which the hinge pin (60) is released from the knuckle (50) such that the hinge pin (60) is free to be displaced out of the knuckle (50) in at least one direction orthogonal to the axis of rotation (A).

2. Electrical enclosure according to claim 1, **characterized in that** the sliding element (42) further comprises a first retainment means (44), the first retainment means (44) having a first abutment surface (45), the hinge mechanism (40) further comprising a second abutment surface (47), the first abutment surface (45) being configured to rest against the second abutment surface (47) to hold the sliding element (42) in the first position (P1).

3. Electrical enclosure according to claim 2, **characterized in that** the hinge mechanism (40) further comprises a third abutment surface (49), the first abutment surface (45) being configured to rest against the third abutment surface (49) when the sliding element (42) is in the second position (P2).

4. Electrical enclosure according to any one of the claims 2 or 3, **characterized in that** the sliding element (42) further comprises a release means (46) configured to displace the first retainment means (44) to separate the first abutment surface (45) from the second abutment surface (47) and/or to separate the first abutment surface (45) from the third abutment surface (49) when pushed by a user.

5. Electrical enclosure according to any one of the claims 2 to 4, **characterized in that** the sliding element (42) comprises a resilient tongue (41), the first retainment means (44) being formed on the resilient tongue (41), the resilient tongue (41) substantially lying in a plane which is parallel to the axis of rotation (A) and/or parallel to the plane within which the door (30) lies when the door (30) is in a closed position.

6. Electrical enclosure according to any one of the claims 1 to 5, **characterized in that** the hinge pin (60) is formed on the frame (22) of the main body (20).

7. Electrical enclosure according to any one of the claims 1 to 6, **characterized in that** the door (30) comprises a receiving portion (32) to which the sliding element (42) is attached in the first position (P1) and/or the second position (P2), wherein preferably the second abutment surface (47) and/or the third abutment surface (49) are formed on the receiving portion (32).

8. Electrical enclosure according to any one of the claims 1 to 7, **characterized in that** the knuckle (50) comprises at least two parts (52, 54), a first part (52) of the at least two parts (52, 54) being formed on the sliding element (42), wherein preferably a second part (54) of the at least two parts (52, 54) is formed on the door (30) or the main body (20).

9. Electrical enclosure according to any one of the claims 1 to 8, **characterized in that** the sliding element (42) further comprises a second retainment means (44a), the second retainment means (44a) having a fourth abutment surface (44b) and the hinge mechanism (40) further comprising a fifth abutment surface (44c), the fourth abutment surface (44b) being configured to rest against the fifth abutment surface (44c) to hold the sliding element (42) in the second position (P2).

10. Method for assembling an electrical enclosure (10) according to any one of the claims 1 to 9, the method comprising the following steps:
a. providing the main body (20), the door (30) and the sliding element (42) of the electrical enclosure (10);
b. positioning the door (30) within the frame (22) of the main body (20);
c. moving the sliding element (42) into the first position (P1) to receive the hinge pin (60) in the knuckle (50) such that the hinge pin (60) is held within the knuckle (50) against any displacement orthogonal to the axis of rotation (A).

11. Method according to claim 10, **characterized in that,** in step c., the sliding element (42) is moved into the first position (P1) by a movement parallel to the plane within which the door (30) lies when the door (30) is in a closed position and/or perpendicular to the axis of rotation (A).

12. Method according to any one of the claims 10 or 11, **characterized in that,** in step c., a first abutment surface (45) of the first retainment means (44) of the sliding element (42) is put to rest against a second abutment surface (47) of the hinge mechanism (40).

13. Method according to any one of the claims 10 to 12, **characterized in that,** in step c., the sliding element (42) is attached to the receiving portion (32) of the door (30) in the first position (P1) and/or the second position (P2).

14. Method according to any one of the claims 10 to 13, **characterized in that,** in step c., the knuckle (50) is formed by pushing one of the at least two parts (52, 54) towards another of the at least two parts (52, 54).
